# EUROPEAN PATENT SPECIFICATION

(11) **EP 3 951 892 B1**
(45) Date of publication and mention of the grant of the patent: **06.12.2023**
(21) Application number: 20931706.4
(22) Date of filing: 11.06.2020
(51) Int. Cl.: H01L 31/048, H01L 31/0216, H02S 30/10

(54) **PHOTOVOLTAIC MODULE**
FOTOVOLTAIKMODUL
MODULE PHOTOVOLTAÏQUE

(30) Priority: 09.05.2020 CN 202010386450
(43) Date of publication of application: 09.02.2022
(73) Proprietor: Ja Solar Technology Yangzhou Co., Ltd., Yangzhou, Jiangsu 225131 (CN)
(72) Inventor: CHEN, Xiaoye, Yangzhou Jiangsu 225131 (CN); JIANG, Xiulin, Yangzhou Jiangsu 225131 (CN)
(74) Representative: Sun, Yiming
(86) International application number: PCT/CN2020/095513
(87) International publication number: WO 2021/227169

(56) References cited:
- CN-A- 103 646 977
- CN-A- 103 646 977
- CN-A- 103 794 658
- CN-A- 103 794 658
- CN-A- 108 091 704
- CN-U- 205 582 951
- JP-A- 2015 095 593
- JP-A- 2015 095 593
- US-A1- 2018 013 024

## Description

### Technical field

The present invention relates to the field of solar photovoltaic technology, in particular to a photovoltaic module.

### Background art

A photovoltaic module is a device which can generate and output electric power after being exposed to light outdoors. At present, the potential induced degradation (PID) effect of a photovoltaic module may lead to deteriorations in the electrical properties of the photovoltaic module. Therefore, it seems very important to obtain a photovoltaic module which is resistant to the PID effect. CN 108091704 A and US 2018/013024 A1 disclose a use of a metal oxide layer as PID protection, inside solar modules comprising glass panels.

### Summary of the invention

In view of this, the embodiments of the present invention provide a photovoltaic module, which can block the migration of alkali metal ions and achieve the PID resistance.

To realize the above purpose, the subject matter of the present invention is defined in claim 1.

An embodiment of the above invention has the following advantages or beneficial effects: migration of alkali metal ions between the glass panel and the cell string can be blocked because of the high bond energy and high stability of the metal-oxygen chemical bonds and/or silicon-oxygen bonds in the first film containing metal oxides and/or silicon oxides disposed between the glass panel and the cell string, and moreover, the metal ions in the metal oxides and/or the silicon ions in the silicon oxides would not migrate, such that the photovoltaic module has the PID resistance.

### Brief Description of the Drawings

FIG. 1 is a schematic diagram illustrating the relative positional relationship among the components included in a photovoltaic module according to an example not part of the present invention;
FIG. 2 is a schematic diagram illustrating the structure of a photovoltaic module according to an example not part of the present invention;
FIG. 3 is a schematic diagram illustrating the structure of a glass panel according to the embodiments of the present invention;
FIG. 4 is a schematic diagram illustrating the structure of a photovoltaic module according to another example not part of the present invention;
FIG. 5 is a schematic diagram illustrating the structure of a photovoltaic module according to an embodiment of the present invention;
FIG. 6 is a schematic diagram illustrating the structure of a cell according to the embodiments of the present invention;
FIG. 7 is a schematic diagram illustrating the relative positional relationship among the components included in a photovoltaic module according to another embodiment of the present invention;
FIG. 8 is a schematic diagram illustrating the structure of a photovoltaic module according to yet another embodiment of the present invention;
FIG. 9 is a schematic diagram illustrating the structure of a photovoltaic module according to another example not part of the present invention;
FIG. 10 is a schematic diagram illustrating the structure of a photovoltaic module according to yet another embodiment of the present invention;
FIG. 11 is a schematic diagram illustrating the structure of a photovoltaic module according to another example not part of the present invention;
FIG. 12 is a schematic diagram illustrating the structure of a photovoltaic module according to yet another example not part of the present invention;
FIG. 13 is a schematic diagram illustrating the structure of a photovoltaic module according to another embodiment of the present invention;
FIG. 14 is a schematic diagram illustrating the structure of a photovoltaic module according to yet another embodiment of the present invention;
FIG. 15 is a schematic diagram illustrating the main process of a method for producing a film according to the embodiments of the present invention;
FIG. 16 is a schematic diagram illustrating the structure the structure of a photovoltaic module according to an example not part of the present invention.

### Reference signs are as follows:

100 photovoltaic module
101 glass panel
1011 first glass panel surface
1012 second glass panel surface
102 back panel
103 cell string
1031 cell
10311 first anti-reflection layer
10312 second anti-reflection layer
104 first film containing metal oxides and/or silicon oxides
105 second film containing metal oxides and/or silicon oxides
106 encapsulation layer
107 frame
108 encapsulation layer corresponding to the frame
109 laminated structure

### Detailed Description of Embodiments

Hereinafter, illustrations will be made in details.

The potential induced degradation (PID) effect of a photovoltaic module is specifically embodied in an electricity leakage area of the photovoltaic module, which reduces the parallel-connected resistances and the fill factors of the photovoltaic module, and even reduces the voltage and current of the photovoltaic module. A research result shows that the main reason for the PID effect is the detection of the accumulation of a large amount of sodium ions on the surface of the cells in the electricity leakage area. The sodium ions in the glass panel (such as ultra clear glass) for the photovoltaic module migrate from the glass panel through the anti-reflection coatings in the cells to the cells under the action of a potential difference. The sodium ions on the cells penetrate the oxide layer of the cells and then accumulate at the silicon chip defect within the cells to form an electricity leakage area.

In addition, a glass panel for a photovoltaic module is generally soda-lime-silica glass. For soda-lime-silica glass, its main body is a network composed of silicon-oxygen chemical bonds. Monovalent alkali metal oxides (such as Na₂O) are added to the silicon-oxygen network, and since oxygen from the monovalent alkali metal oxides is more than that in the silicon-oxygen network, part of the silicon-oxygen bonds will be broken such that "non-bridging oxygen" appears in the glass network body. Such non-bridging oxygen will have a negative charge because it does not completely form chemical bonds, and at this time, sodium ions will be adsorbed near the non-bridging oxygen to neutralize the charge of the non-bridging oxygen. Since the volume of sodium ions is not very large, migration of sodium ions would easily occur under the action of a potential difference of the photovoltaic module. That is, the electrical conductivity of glass is caused by monovalent alkali metal ions.

Through further research, it is found that: divalent calcium ions in a soda-lime-silica glass system can strongly attract non-bridging oxygen that does not form a bond, and the glass network as a whole is strengthened as a result of more charges of the divalent calcium ions. In addition, after calcium ions attract non-bridging oxygen that does not form a bond, they are not only difficult to be moved but also hinder the migration of sodium ions. However, the property of the glass is isotropic due to the disorder of the structure thereof, and therefore, the migration of sodium ions is also isotropic. In this way, migration of sodium ions still inevitably exists in a soda-lime-silica glass system.

Generally speaking, there are mainly two sources for sodium ions which migrate in a photovoltaic module: one source is the sodium ions in the glass panel; the other source is the sodium ions generated by subjecting the encapsulation layer, which is used to encapsulate a cell string between a glass panel and a back panel, to hydrolysis and then reacting the encapsulation layer with the glass panel. Therefore, the PID resistance can be effectively achieved by blocking the direct contact between a glass panel and an encapsulation layer or blocking the path of the migration of sodium ions from the glass panel to the cells.

In the embodiments of the present invention, the following technical means is adopted to realize the PID resistance of the photovoltaic module.

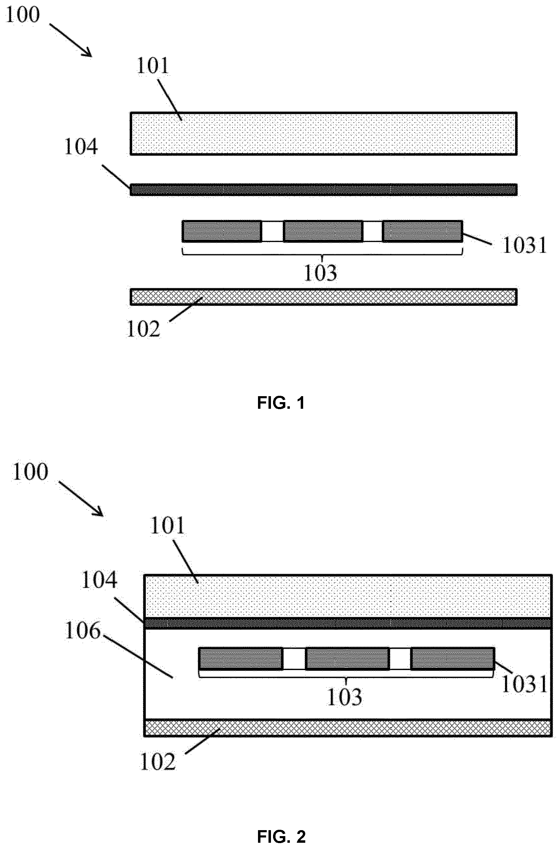

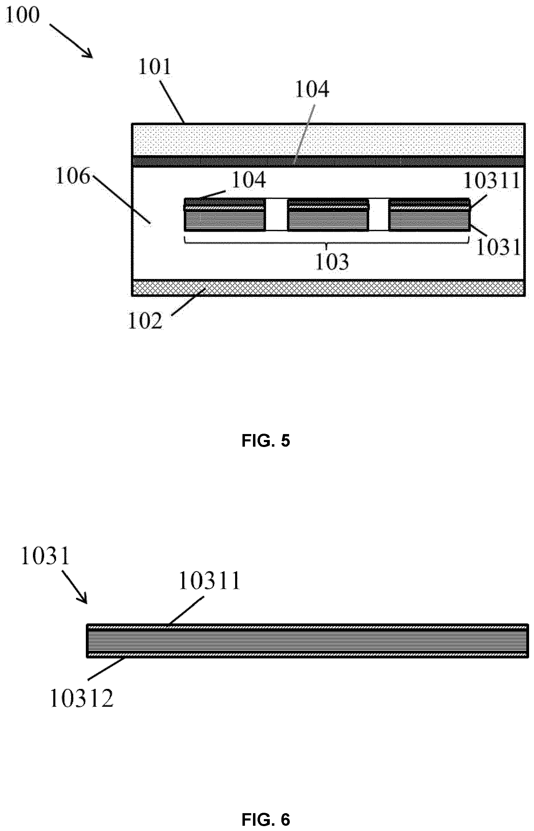

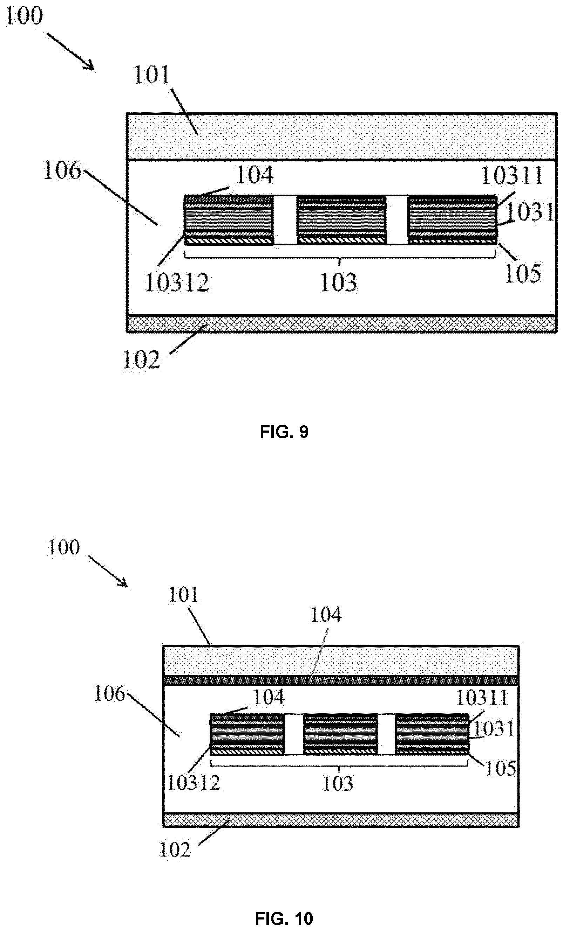

FIGs. 5, 8, 10, 13 and 14 show a photovoltaic module 100 according to the embodiments of the present invention. As shown in FIGs. 1, 2, 4 and 5, the photovoltaic module 100 comprises: a glass panel 101, a back panel 102, and a cell string 103 including a plurality of cells 1031 encapsulated between the glass panel 101 and the back panel 102; and a first film 104 containing metal oxides and/or silicon oxides (hereinafter referred to as a first film 104) disposed between the glass panel 101 and the cell string 103.

Specifically, FIG. 1 shows a relative positional relationship among the glass panel 101, the back panel 102, the cell string 103 including a plurality of cells 1031, and the first film 104.

### Herein, the position of the first film 104 is adjustable.

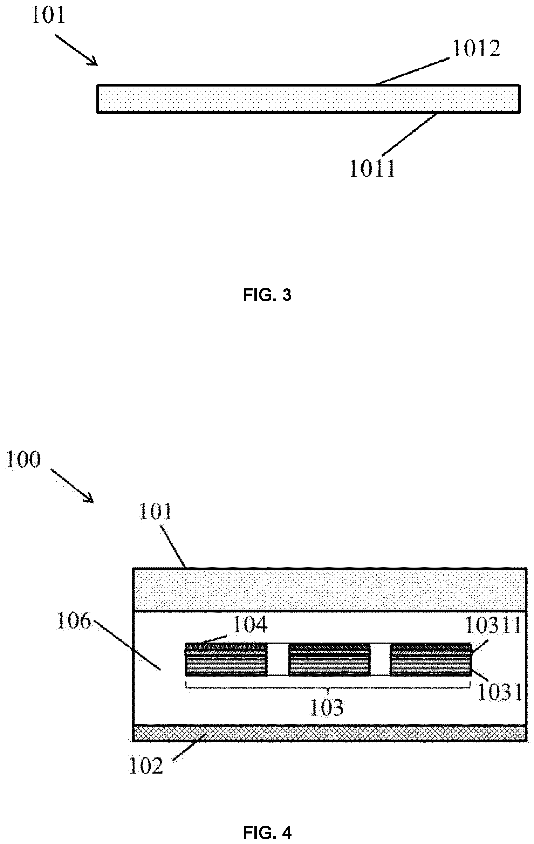

Specifically, as shown in FIG. 2, the first film 104 is deposited on the glass panel 101. It should be noted that: as shown in FIG. 3, the glass panel 101 includes two parallel main surfaces which are a first glass panel surface 1011 and a second glass panel surface 1012, respectively. Based on the relative positional relationship shown in FIG. 1, the deposition of the first film 104 on the glass panel 101 substantively means that: when the first glass panel surface 1011 is opposite to the cell string, the first film 104 is deposited on the first glass panel surface 1011; when the second glass panel surface 1012 is opposite to the cell string, the first film 104 is deposited on the second glass panel surface 1012. In other words, the first film 104 is deposited on a surface of the glass panel 101 close to the cell string 103.

As shown in FIG. 4, the first film 104 is deposited on all the cells 1031 included in the cell string 103.

As shown in FIG. 5, the first film 104 is deposited on the glass panel 101 and at least one cell 1031. More preferably, the first film 104 is deposited on the glass panel 101 and on all the cells 1031 included in the cell string 103.

It should be noted that: as shown in FIG. 6, the cell 1031 may include a first anti-reflection layer 10311 and/or a second anti-reflection layer 10312. Based on the relative positional relationship shown in FIG. 1, the deposition of the first film 104 on the cell 1031 substantively means that: the first anti-reflection layer 10311 is opposite to the glass panel 101, the second anti-reflection layer 10312 is opposite to the back panel 102, and the first film 104 is deposited on the first anti-reflection layer 10311, wherein the first anti-reflection layer 10311 can effectively reduce the reflection of light passing through the glass panel 101, and the second anti-reflection layer 10312 can effectively reduce the reflection of light passing through the back panel 102, thereby effectively increasing the light energy entering the cell string 103.

By pre-depositing the first film 104 on the glass panel 101 as shown in the above FIGs. 2 and 5, or pre-depositing the first film 104 on the cells in FIGs. 4 and 5, under the precondition that the PID resistance is achieved, the production process of the photovoltaic module can be simplified and the integrity of the film structure of the first film 104 can be ensured so as to effectively block the migration of alkali metal ions.

As for the photovoltaic module shown in FIGs. 2, 4 and 5, because of the presence of a first film on the glass panel and/or the presence of a first film on the cells, and meanwhile, because of the high bond energy and high stability of metal-oxygen chemical bonds and/or silicon-oxygen bonds in the metal oxides and/or silicon oxides included in the first film, alkali metal ions in the glass panel can be blocked from passing through the first film containing metal oxides and/or silicon oxides, and thereby migration of alkali metal ions between the glass body and the cells can be blocked, such that the photovoltaic module has the PID resistance.

In the photovoltaic module, the glass panel 101 can be obtained by cutting the existing glass. In an embodiment, the glass panel 101 is ultra clear glass or ultra white glass. Since the ultra clear glass has high light transmittance (up to more than 91.5%), even if in the presence of the first film 104 containing metal oxides and/or silicon oxides, the ultra clear glass can still ensure the light energy entering the cell string, such that the photovoltaic module has good practicability and usability.

Herein, the first film 104 containing metal oxides and/or silicon oxides refers to any one or more of a film containing metal oxides, a film containing silicon oxides, and a film containing metal oxides and silicon oxides.

When the first film 104 is any one of a film containing metal oxides, a film containing silicon oxides, and a film containing metal oxides and silicon oxides, the first film 104 may have a single-layer or a laminated structure, wherein a single-layer structure refers to a structure in which a single-layer film of any type is used as the first film 104, and a laminated structure refers to a structure in which films of any type are laminated as a multi-layer structure.

When the first film 104 is more of a film containing metal oxides, a film containing silicon oxides, and a film containing metal oxides and silicon oxides, the first film 104 may have a laminated structure, wherein the film containing metal oxides and silicon oxides means that a single-layer film contains metal oxides and silicon oxides.

In an embodiment of the present invention, the first film 104 may have a thickness of 2 to 5000nm. The thickness can be set accordingly according to the requirements of the photovoltaic module, such as 5nm, 15nm, 20nm, 50nm, 100nm, 120nm, 150nm, 200nm, 220nm, 250nm, 260nm, 280nm, 400nm, 600nm, 1000nm, 1500nm, 2000nm, 2500nm, 3000nm, 4000nm, 5000nm and so on. It is found through research that: the first film 104 having a thickness of 2 to 5000 nm will not affect other properties of the photovoltaic module while achieving the PID resistance. More preferably, the first film 104 may have a thickness of 10-300 nm.

In an embodiment of the present invention, because the first glass panel surface 1011 of the glass panel 101 is opposite to the cell string 103, the film containing metal oxides and/or silicon oxides can also be deposited on the second glass panel surface 1012 of the glass panel 101. In other words, under the precondition of the presence of the first film 104, the film containing metal oxides and/or silicon oxides may be also deposited on a surface of the glass panel 101 away from the cell string 103.

In an embodiment of the present invention, the film containing metal oxides and/or silicon oxides may be also deposited on a part or whole of the side walls of the glass panel 101, wherein the side walls of the glass panel 101 intersect the first glass panel surface 1011 and the second glass panel surface 1012 of the glass panel 101, which further blocks the migration path of sodium ions.

In an embodiment of the present invention, the above first film containing metal oxides and/or silicon oxides or a film containing metal oxides and/or silicon oxides may be obtained by a vapor deposition method or a spray pyrolysis method. Preferably, the above first film containing metal oxides and/or silicon oxides or a film containing metal oxides and/or silicon oxides may be obtained by a spray pyrolysis method.

In the embodiments of the present invention, the material of the back panel 102 may be a polymer transparent panel, a glass panel and the like. In the photovoltaic module, the function of the back panel 102 is to provide back support so as to support the cell string 103.

In an embodiment of the present invention, the material of the back panel 102 may be glass.

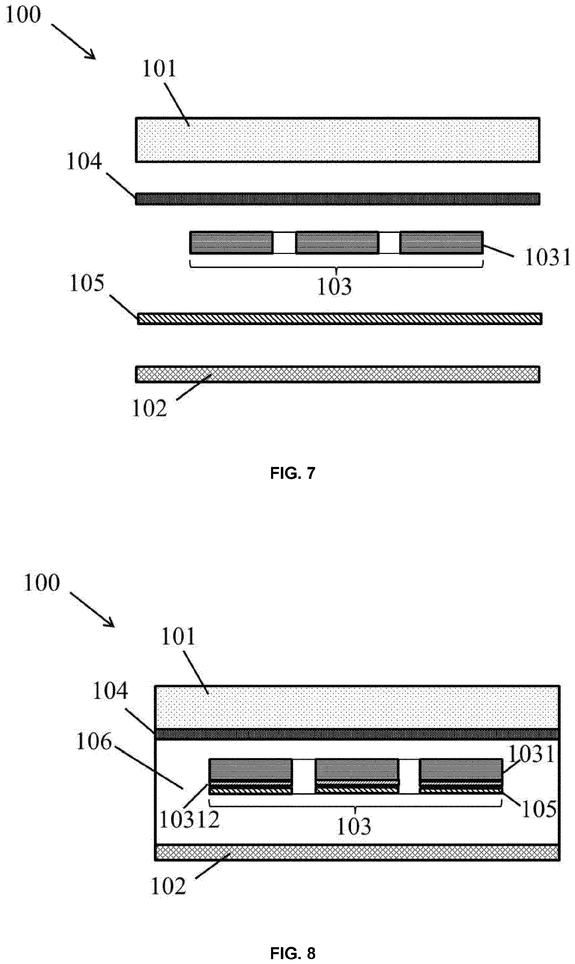

As shown in FIGs. 7 to 13, the photovoltaic module further comprises a second film 105 containing metal oxides and/or silicon oxides disposed between the back panel 102 and the cell string 103 (hereinafter referred to as a second film 105).

Specifically, FIG. 7 shows a relative positional relationship among the glass panel 101, the back panel 102, the cell string 103 including a plurality of cells 1031, the first film 104 and the second film 105.

In the photovoltaic module, both the position of the first film 104 and the position of the second film 105 are adjustable. The preceding FIGs. 2, 4 and 5 have illustrated the deposition positions of the first film 104 in details. FIGs 8 to 14 show a photovoltaic module comprising the second film 105 and also show the position of the second film 105 in the photovoltaic module.

Specifically, on the basis of FIGs. 2, 4 and 5, the second film 105 is deposited on at least one of the cells 1031 as shown in FIGs. 8 to 10. Based on the relative positional relationship among the back panel 102, the cell string 103, and the second film 105 as shown in FIG. 7, the deposition of the second film 105 on the cells 1031 substantively means that: when the cell 1031 includes a first anti-reflection layer 10311 which is opposite to the glass panel 101 and a second anti-reflection layer 10312 which is opposite to the back panel 102 as shown in FIG. 6, the second film 105 is deposited on the second anti-reflection layer 10312 .

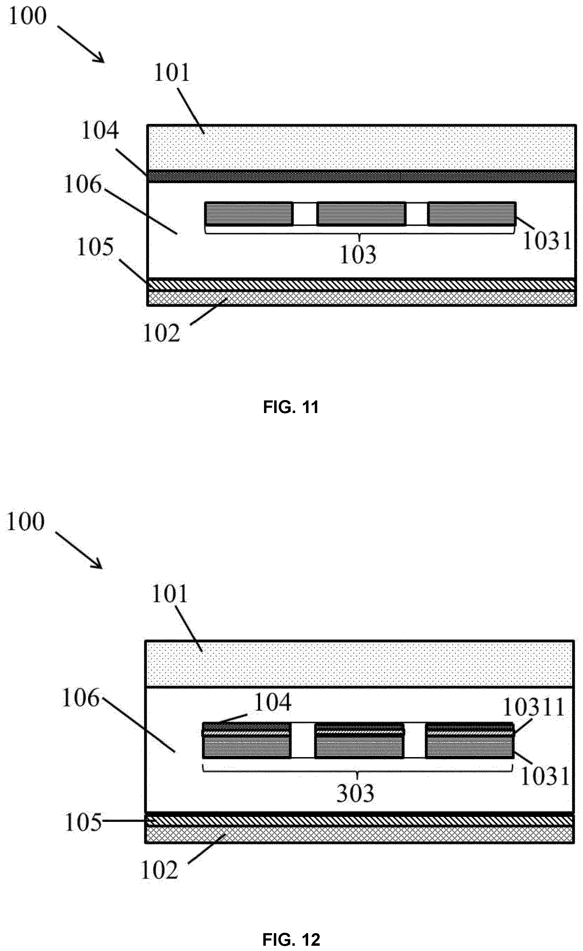

In addition, on the basis of FIGs. 2, 4 and 5, the second film 105 is deposited on the back panel as shown in FIGs. 11 to 13. It should be noted that the back panel 102 includes two parallel main surfaces, which are a first back panel surface and a second back panel surface, respectively. Based on the relative positional relationship as shown in FIG. 7, the deposition of the second film 105 on the back panel 102 substantively means that: when the first back panel surface is opposite to the cell string, the second film 105 is deposited on the first back panel surface; when the second back panel surface is opposite to the cell string, the second film 105 is deposited on the second back panel surface.

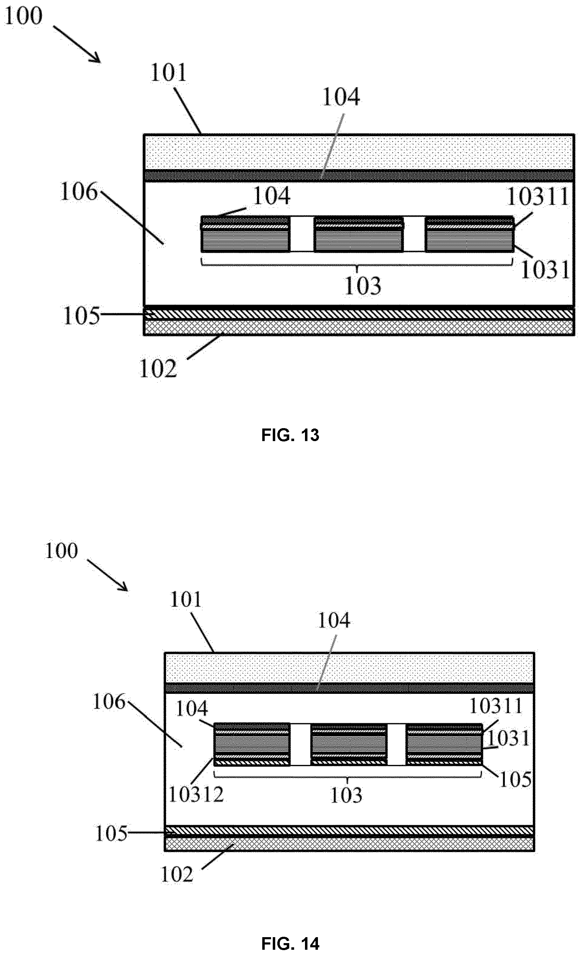

In addition, on the basis of FIGs. 2, 4 and 5, the second film 105 can be also deposited on at least one cell 1031 and the back panel 102 simultaneously in an embodiment as shown in FIG. 14.

Herein, the second film 105 containing metal oxides and/or silicon oxides refers to any one or more of a film containing metal oxides, a film containing silicon oxides, and a film containing metal oxides and silicon oxides.

When the second film 105 is any one of a film containing metal oxides, a film containing silicon oxides, and a film containing metal oxides and silicon oxides, the second film 105 may have a single-layer or a laminated structure, wherein a single-layer structure refers to a structure in which a single-layer film of any type is used as the second film 105, and a laminated structure refers to a structure in which films of any type are laminated as a multi-layer structure.

When the second film 105 is more of a film containing metal oxides, a film containing silicon oxides, and a film containing metal oxides and silicon oxides, the second film 105 may have a laminated structure, wherein the film containing metal oxides and silicon oxides means that a single-layer film contains metal oxides and silicon oxides.

In an embodiment of the present invention, regardless of whether it is the first film 104 or the second film 105, a film of metal oxides included therein is formed by the decomposition of metal organic compounds, and the valence states of metals in the metal organic compounds are generally not less than +2 valence. Metal organic compounds from which metal oxides can be obtained by thermal decomposition can be used as reaction raw materials of a film of metal oxides, such as acetic acid compounds of metals and acetylacetonate compounds of metals.

In an embodiment of the present invention, regardless of whether it is the first film 104 or the second film 105, a film of silicon oxides included therein is obtained by decomposition of silicon organic compounds.

In an embodiment of the present invention, regardless of whether it is the first film 104 or the second film 105, a film of metal oxides and silicon oxides included therein is obtained by decomposition of a mixture containing metal organic compounds and silicon organic compounds.

In an embodiment of the present invention, metal oxides include, but are not limited to, any one or more of aluminum oxide, zinc oxide, zirconium oxide, titanium oxide, and tin oxide. Understandably, a film of metal oxides may be a film of a single type of metal oxides, such as an aluminum oxide film, a zinc oxide film, a zirconium oxide film, a titanium oxide film, and so on; a film of metal oxides may be also be a film of metal oxides mixed by more types of metal oxides, such as a film of metal oxides in which aluminum oxide, zinc oxide, and zirconium oxide coexist; the film of metal oxides may be also formed by stacking multiple layers of metal oxides films with different components, for example, formed by stacking an titanium oxide film and a oxide film mixed by zinc oxide and zirconium oxide.

In addition, regardless of whether it is the first film 104 or the second film 105, it may also include other film layers, such as an ethylene-vinyl acetate copolymer film (EVA film), a vinyl olefin copolymer film, and the like.

In an embodiment of the present invention, the second film 105 may have a thickness of 2 to 5000nm. The thickness can be set accordingly according to the requirements of the photovoltaic module, such as 5nm, 15nm, 20nm, 50nm, 100nm, 120nm, 150nm, 200nm, 220nm, 250nm, 260nm, 280nm, 400nm, 600nm, 1000nm, 1500nm, 2000nm, 2500nm, 4000nm, 5000nm and so on. It is found through research that the second film 105 having a thickness of 2 to 5000 nm will not affect other properties of the photovoltaic module while achieving the PID resistance. More preferably, the second film 105 may have a thickness of 10-300 nm.

As shown in FIGs. 2, 4, 5 and 8 to 14, the photovoltaic module may also comprise:
an encapsulation layer 106 for encapsulating the cell string 103 between the glass panel 101 and the back panel 102,
wherein a surface of the first film 104 is in contact with the encapsulation layer 106, and
wherein, the encapsulation layer 106 may be formed of an EVA material.

In addition, the above photovoltaic module may also comprise a bus bar, an inverter, and a connector (not shown in FIGs), which are consistent with those in an existing photovoltaic module with regards to the position and connection manner (details are omitted).

In an embodiment of the present invention, the thickness of the first anti-reflection layer 10311 is determined by the thickness of the first film 104, or the thickness of the first film 104 is determined by the thickness of the first anti-reflection layer 10311, so as to satisfy the requirements of the photovoltaic module on the refractive index of the first anti-reflection layer.

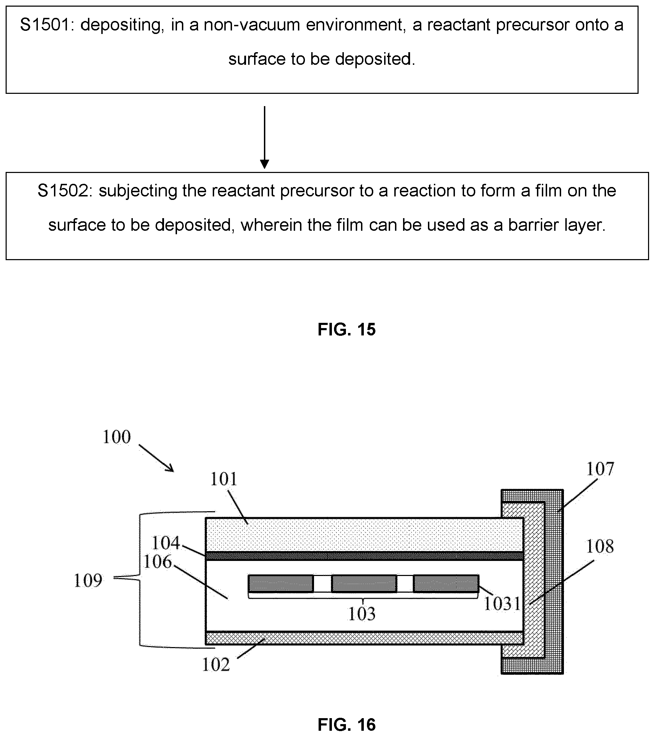

The production method for the first film 104 and the second film 105 provided in the above embodiments may be as shown in FIG. 15. As shown in FIG. 15, the embodiments of the present invention provide a production method for a thin film, comprising the following steps:
S1501: depositing, in a non-vacuum environment, a reactant precursor onto a surface to be deposited;
S1502: subjecting the reactant precursor to a reaction to form a film on the surface to be deposited, wherein the film can be used as a barrier layer.

Among the steps, the specific implementation of the above step S1501 may include: atomizing the reactant precursor, and depositing and adsorbing the atomized reactant precursor to the surface to be deposited, wherein the reactant precursor may include solvents, metal organic compounds and/or silicon organic compounsd, and the like; wherein the surface to be deposited may be a main surface of the glass panel or a main surface of the cell, and specifically may also be a main surface of the glass panel 101 or a main surface of the cell 1031; wherein the cell 1031 may include an anti-reflection layer.

When the surface to be deposited is an anti-reflection layer of the cell 1031, the thickness of the anti-reflection layer can be adjusted to cause, in cooperation with the production method for the film, the film produced on the surface of the anti-reflection layer to be capable of realizing the optimal optical anti-reflection function of the anti-reflection layer of the cell.

The specific implementation of the above step S1502 may include: controlling the temperature increase of the surface to be deposited to volatilize the solvents, and decomposing the metal organic compounds to form a barrier layer including a film containing metal oxides and/or silicon oxides.

It should be noted that the above steps S1501 and S1502 can be repeated multiple times to form multiple layers of films containing metal oxides and/or silicon oxide on the surface to be deposited.

In an embodiment of the present invention, the metal organic compounds included in the above reactant precursor may include any one or more of an organic compound of aluminum, an organic compound of zinc, an organic compound of zirconium, an organic compound of titanium, and an organic compound of tin. For example, the metal organic compounds may be acetic acid compounds of metals and acetylacetonate compounds of metals.

In an embodiment of the present invention, the valence states of the metals in the metal organic compounds included in the above reactant precursor are generally not less than +2.

In an embodiment of the present invention, the specific implementation of atomizing the reactant precursor may include: atomizing the reactant precursor into atomized droplets using ultrasonic waves, wherein the atomized droplets are a atomized reactant precursor.

In an embodiment of the present invention, when atomizing the reactant precursor into atomized droplets using ultrasonic waves, the frequency of the ultrasonic waves may be 20-10⁶ KHz. That is, the frequency of the ultrasonic waves may be any value in the range of 20 to 10⁶ KHz. For example, the frequency of the ultrasonic waves may be 20 KHz, 40 KHz, 50 KHz, 80 KHz, 85 KHz, 100 KHz, 10³ KHz, 10⁴ KHz, 10⁵ KHz, 10⁶ KHz and so on.

In addition, the atomized droplets can be transported through a pipeline to a reaction chamber, so that the atomized droplets are deposited and adsorbed to the surface to be deposited of an object placed in the reaction chamber, and the surface to be deposited of the object may be a main surface of the glass or an anti-reflection layer of the cell, wherein the flow rate of the atomized droplets is 2×10⁻⁴-10 L/min, and as obtained through specific experiments, this flow rate can not only ensure the uniformity of the deposition of the atomized droplets, but also can ensure that the thickness of the film (containing metal oxides and/or silicon oxides) formed by decomposition can satisfy the requirements. The flow rate of the atomized droplets is 2×10⁻⁴-10 L/min, that is, the flow rate of the atomized droplets may be any value in the range of 2×10⁻⁴ to 10 L/min, such as 2×10⁻⁴ L/min, 5×10⁻⁴ L/min, 2×10⁻³ L/min, 6×10⁻³ L/min, 1×10⁻² L/min, 5×10⁻² L/min, 0.3 L/min, 0.8 L/min, 0.9 L/min, 4 L/min, 5 L/min, 7 L/min, 10 L/min, etc.

In an embodiment of the present invention, a temperature for controlling the temperature increase of the surface to be deposited may be 100-600 degrees (°C). That is, a temperature of the surface to be deposited may be increased to any value in the range of 100 to 600 degrees, such as 100 degrees, 150 degrees, 200 degrees, 250 degrees, 400 degrees, 400 degrees, 500 degrees, 600 degrees, and so on.

In addition, in an embodiment of the present invention, a period for deposition and adsorption may be 0.5-40 minutes. Understandably, when the flow rate of the atomized droplets is higher, the corresponding period for deposition and adsorption period may be accordingly shorter, and when the flow rate of the atomized droplets is lower, the corresponding period for deposition adsorption may be accordingly longer.

Understandably, the concentration of the organic compounds (metal organic compounds and/or silicon compounds) included in the above reactant precursor, the flow rate of the atomized droplets, and the period for the deposition and adsorption can affect the thickness of the film, wherein the concentration of the organic compounds, the flow rate of the atomized droplets and the period for the deposition and adsorption are proportional to the thickness of the film, respectively. However, the frequency of ultrasonic waves can affect the flow rate of the atomized droplets.

In a preferred embodiment, the above production method for a film may be realized by spray pyrolysis, and the above control for the temperature increase of the surface to be deposited can be realized by heating a carrier panel. The carrier panel is a device that can carry the glass or the cell body.

As for the production of a film on the glass panel, it can be realized in two manners:
Manner I: A corresponding surface of the glass is placed in a chamber for deposition by spray pyrolysis, in which the reactant precursor is sprayed and deposited on the corresponding surface, and then the reactant precursor is pyrolyzed to form a film.
Manner II: A spray pyrolysis device is disposed on a production line of float glass, and during the production of float glass, a sprayer unit is disposed in an appropriate temperature area at the cooling stage. The reaction precursor is sprayed directly on a surface of hot glass, and a pyrolysis reaction is realized by utilizing the residual glass-melting temperature, such glass with a film is obtained. The obtained glass can be used as the glass panel of the photovoltaic module, and can also be used as the back panel of the photovoltaic module. That is to say, this manner is a preparation method for glass or glass panel, in which during the preparation of glass or a glass panel by the float process, at the cooling stage of the glass or glass panel, the reactant precursor is dispersed on one or two main surfaces of the glass or glass panel, the reactant precursor is subjected to a reaction by utilizing the residual temperature of the glass or glass panel, such that a film is formed on one or two main surfaces of the glass or glass panel.

In addition, the embodiments of the present invention further provide a preparation method for a photovoltaic module, comprising the above preparation method for glass or a glass panel, and comprising preparing a photovoltaic module using the glass or glass panel prepared by the above preparation method. A specific photovoltaic module structure is the photovoltaic module provided in this text.

In addition, the embodiments of the present invention further provide a preparation method for a solar cell, comprising the above process of forming a film. Specifically, for example, in the process of preparing a solar cell, the method comprises forming a film on one or two main surfaces of the solar cell using the above method. For another example, in a process of preparing a solar cell, the method also comprises a process of forming an anti-reflection layer, and comprises forming a film on the anti-reflection layer using the above method after the anti-reflection layer is formed. In addition, the embodiments of the present invention also provide a manner for forming a matrix of solar cells. Specifically, in the process of forming a matrix of solar cells, a film is formed on the matrix of the solar cells using the above method. The matrix of the solar cells may be in a single column or multiple columns. When the matrix of the solar cells is in multiple columns, it may comprise 6 columns × 12 rows of solar cells. A solar cell may be square or rectangular. When the solar cell is rectangular, the aspect ratio of the rectangle may be 6:1 to 2:1, such as 5:1, 4:1, 3:1, and so on. When the aspect ratio of the rectangle is 2:1, the solar cell can be considered as a solar cell in a semi-slice mode commonly referred to in the field. When the aspect ratio of the rectangle is 6:1 to 3:1, the solar cell can be considered as a shingled cell or a cell connected roughly in one plane as commonly referred to in the field.

In addition, the embodiments of the present invention also provide a solar cell comprising the above film or barrier layer. In addition, the embodiments of the present invention also provide a matrix of solar cells including the above-mentioned film. In the embodiments of the present invention, the solar cell or solar sheet-like cell may be a crystalline silicon solar cell or a crystalline silicon sheet-like cell, a film solar cell or a film solar sheet-like cell.

As for the production of a film on an anti-reflection layer of the cell, the film may be produced on a first anti-reflection layer of the cell opposite to the glass panel of the photovoltaic module, the film may be also produced on a second anti-reflection layer of the cell opposite to the back panel of the photovoltaic module, and the film may be further produced on a first anti-reflection layer and a second anti-reflection layer.

It should be noted that: the above production method for a film can be also applied to other glass in addition to the ultra clear glass of the photovoltaic module.

A device used in the spray pyrolysis method does not require vacuuming and does not use a plasma generation means, which is able to effectively reduce energy consumption and has a low cost. The sprayer unit used in the spray pyrolysis method is easy to be designed and suitable for large-area production. In addition, in the embodiments of the present invention, low-cost reaction raw materials may be selected, and the process is mature and simple, which allows deposition of a film in a large area and makes it convenient and suitable for industrialized mass production, and which at the same time makes it easy to control or reduce the cost.

In an embodiment of the present invention, the concentration of the organic compounds (metal organic compounds and/or silicon organic compounds) included in the above reactant precursor is 0.001-0.8 mol/L. Through a study of the concentration of the organic compounds, the concentration range selected in the embodiment of the present invention can, on the one hand, ensure that the metal organic compounds are decomposed into a film of metal oxides, the silicon organic compounds are decomposed into a film of silicon oxides, and a mixture of metal organic compounds and silicon organic compounds are decomposed into a film containing metal oxides and silicon oxides; and on the one hand, can reduce the waste of organic compounds. It should be noted that: the concentration 0.001-0.8 mol/L of the organic compounds included in the reactant precursor means that the concentration of the organic compounds included in the reactant precursor may be any value in the range of 0.001 to 0.8 mol/L, such as 0.001 mol/L, 0.005 mol/L, 0.009 mol/L, 0.01 mol/L, 0.05 mol/L, 0.08 mol/L, 0.1 mol/L, 0.4 mol/L, 0.5 mol/L, 0.8 mol/L.

In an embodiment of the present invention, the period for deposition and adsorption is 0.5 to 40 minutes. That is, the period for deposition and adsorption may be any value in the range of 0.5 to 40 minutes, such as 0.5 minutes, 5 minutes, 8 minutes, 15 minutes, 20 minutes, 25 minutes, 40 minutes, etc.

Based on the adjustments to the concentration range (0.001-0.8 mol/L) of the organic compounds, the flow rate range (2×10⁻⁴-10 L/min) of the atomized droplets, and the period (0.5-40 minutes) for deposition and adsorption, and the frequency range (20-106 KHz) of ultrasonic waves as provided in the embodiments of the present invention, deposition of a film containing metal oxides and/or silicon oxides on ultra clear glass and deposition of a film containing metal oxides and/or silicon oxides on the cells can be realized.

In an embodiment of the present invention, the solvents included in the above reactant precursor are alcohols and/or water. The alcohols may be selected from methanol, ethanol and the like which are inexpensive.

The ratio of alcohols to water in the solvents may be 0:100 to 100:0. Understandably, when water is used alone as the solvent, the metal organic compounds need to be soluble in water.

The above production method for a film may further comprise:
when the surface to be deposited is the first anti-reflection layer included in the cell, adjusting the thickness of the film containing metal oxides and/or silicon oxides according to the thickness of the first anti-reflection layer;
when the surface to be deposited is a main surface of the glass, in a case where the glass on which a film is deposited is used as the glass panel of the photovoltaic module and the film is opposite to the first anti-reflection layer included in the cell, determining, according to the thickness of the film, the thickness of the first anti-reflection layer included in the cell to select suitable cells so as to ensure better properties of the photovoltaic module.

In order to clearly illustrate the production method for a barrier layer, several embodiments are provided for illustrations as follows:

### Embodiment 1:

A film (an aluminum oxide film) was produced for ultra clear glass by the spray pyrolysis method, comprising the following steps:
A1: Preparation of a surface to be deposited: Ultra clear glass for the photovoltaic module which had been cut was selected, and a surface to be deposited was cleaned.
A2: Formulation of a spray solution: Aluminum acetylacetonate was selected as a thermal decomposition substance, and methanol and water were selected as solvents, wherein the concentration of the formulated aluminum acetylacetonate solution was 0.08 mol/L.
A3: Deposition of an aluminum oxide film: The surface to be deposited of the ultra clear glass (a coated surface of the ultra clear glass) was placed within a carrier panel of the machine, the reaction temperature was controlled to 400 degrees, ultrasounds with a frequency of 20 MHz were enabled to generate sprays, and the sprays were introduced into the deposition chamber such that spray droplets containing the reactant precursor were spread uniformly on the surface of the glass to be deposited. The spray droplets gradually volatilized under the action of heat, and meanwhile a uniform aluminum oxide film was produced on the surface of the glass after the aluminum acetylacetonate was thermally decomposed, wherein the period for deposition was 10 minutes and the thickness of the obtained aluminum oxide film was 20 nanometers.

In the above step A1, cleaning of the surface to be deposited may be wiping with a dust-free cloth which is sprayed with alcohol.

In the above step A2, the concentration of the solution and the period for deposition can be adjusted according to the requirements on the thickness of the deposited film.

Understandably, the above control of the temperature increasing process of the reaction temperature may be performed simultaneously with the step A2, or the control of an increase of the reaction temperature can be started after a continuous period for deposition in the step A2, or the temperature can be increased upon the completion of the step A2 so as to reach the reaction temperature.

### Embodiment 2:

A film (a titanium oxide film) was produced for ultra clear glass by the spray pyrolysis method, comprising the following steps:
B1: Preparation of a surface to be deposited: Ultra clear glass for use in the photovoltaic field which had been cut was selected, and a surface to be deposited was cleaned.
B2: Formulation of a spray solution: Titanium acetate was selected as a thermal decomposition substance, and ethanol or water was selected as a solvent, wherein the concentration of the formulated titanium acetate solution was 0.06 mol/L.
B3: Deposition of a titanium oxide film: The coated surface of the glass was placed within a carrier panel of the machine, the reaction temperature was 400 degrees, ultrasounds were enabled to generate sprays, and the sprays were introduced into the deposition chamber such that spray droplets containing the reactant precursor were spread uniformly on the surface of the glass to be deposited. The solvent gradually volatilized under the action of heat, and meanwhile a uniformly distributed titanium oxide film was produced on the surface of the glass after the titanium acetate was decomposed, wherein the period for deposition was 10 minutes and the thickness of the obtained titanium oxide film was 15 nanometers.

### Embodiment 3:

A film (a zirconium oxide film) is produced on an anti-reflection layer of the cell by the spray pyrolysis method, comprising the following steps:
C1: Formulation of a spray solution: zirconium acetate was selected as a thermal decomposition substance, and a mixture of methanol and water was selected as a solvent, wherein the concentration of the formulated zirconium acetate solution is 0.5 mol/L.
C2: Deposition of a zirconium oxide film: A cell was placed within a carrier panel of the machine (an anti-reflection layer of the cell was used as a surface to be treated for receiving the atomized droplets), the reaction temperature was controlled to 400 degrees, ultrasounds with a frequency of 800MHz were enabled to generate sprays, and the sprays were introduced into a deposition chamber such that spray droplets containing a reaction precursor were uniformly spread on a surface of the glass to be deposited; the spray droplets gradually volatilized under the action of heat, and meanwhile a uniform aluminum oxide film was produced on the surface of the glass after the aluminum acetylacetonate was thermally decomposed, wherein the period for deposition was 5 minutes and the thickness of the obtained aluminum oxide film was 10 nanometers

The embodiments of the present invention also provide a production method for a photovoltaic module, comprising the following steps:
a step of building a photovoltaic module, wherein a first film containing metal oxides and/or silicon oxides is present between the glass panel and the cell string included in the photovoltaic module;
a step of organizing the photovoltaic module.

Among the steps, the specific implementation of the step of building a photovoltaic module may include: performing a laminating operation in an arrangement sequence of the glass panel 101, the encapsulation layer 106, the cell string 103 including the cells 1031, the encapsulation layer 106, and a back panel 102 to obtain the photovoltaic module 100. For example, when the first film 104 is deposited on the glass panel 101, the photovoltaic laminated module 100 shown in FIG. 2 can be obtained by the above step; when the first film 104 is deposited on the first anti-reflection layer 10311 of the cell 1031, the photovoltaic module 100 shown in FIG. 4 can be obtained by the above step; when the first film 104 is deposited on both the glass panel 101 and the first anti-reflection layer 10311 of the cell 1031, the photovoltaic module 100 shown in FIG. 5 can be obtained by the above step; in addition, the photovoltaic laminated module 100 shown in FIGs. 8 to 14 can be also obtained by the above step (details are omitted).

Among the steps, the specific implementation of the step of organizing the photovoltaic module may include deburring and cleaning the module. In this step, cleaning and wiping with alcohol or the like may be used to remove an encapsulation material caused by lamination, such as an EVA material overflowing from the surface.

In an embodiment of the present invention, through experimental tests, the temperature of the above laminating operation is 150 degrees.

In an embodiment of the present invention, through experimental tests, the temperature of the above laminating operation is 10 degrees.

The temperature of the above laminating operation and the period for the laminating operation are determined based on the combined action of a film containing metal oxides and/or silicon oxides (the first film 104 containing metal oxides and/or silicon oxides and/or the second film 105 containing metal oxides and/or silicon oxides) present in the photovoltaic module and others, such as the glass panel 101 which is ultra clear glass, the encapsulation layer 106, the cell string 103, and the back panel 102. The temperature of the above laminating operation and the period for the above laminating operation result in better properties of the photovoltaic module, such as the PID resistance, the stability and the like.

In an embodiment of the present invention, the production method for a photovoltaic module may further comprise: adjusting the relationship between the thickness of the first anti-reflection layer 10311 and the thickness of the first film 104 disposed between the glass panel 101 and the cells 1031. Specifically, the thickness of the first anti-reflection layer 10311 can be determined according to the thickness of the first film 104 disposed between the glass panel 101 and the cells 1031, or the thickness of the first film 104 disposed between the glass panel 101 and the cells 1031 can be determined by the thickness of the first anti-reflection layer 10311.

In an embodiment of the present invention, the photovoltaic module 100 shown in FIG. 16 is taken as an example for illustration. The photovoltaic module 100 may further comprise: a frame 107 and an encapsulation layer 108 corresponding to the frame.

In the photovoltaic module 100, the glass panel 101, the back panel 102, the cell string 103 including a plurality of cells 1031, the first film 104 deposited on the glass panel 101, and the encapsulation layer 106 for encapsulating the cell string 103 between the glass panel 101 and the back panel 102 are subjected to a laminating operation to form a laminated structure 109.

The encapsulation layer 108 corresponding to the frame is disposed between the frame 107 and the laminated structure 109.

Herein, the encapsulation layer 108 corresponding to the frame means that: when the laminated structure 109 of the photovoltaic module is encapsulated into the frame 107 using an encapsulation material, the encapsulation material is cured into an encapsulation layer 108 corresponding to the frame. The encapsulation material can be an adhesive material such as silica gel.

Hereafter, two embodiments are provided for detailed illustrations of the production method for the photovoltaic module.

### Embodiment 4:

D1: Welding the tested crystalline silicon cells to form a cell string.

In this step, welding may be performed manually or by a welding machine.

D2: Preparing the materials required for the production of the module: ultra clear glass including a first film containing metal oxides and/or silicon oxides, an EVA material for encapsulation, a cell string, a back panel, silica gel, and a frame.

D3: Arranging in a sequence of ultra clear glass including a first film containing metal oxides and/or silicon oxides, an EVA material for encapsulation, a cell string, EVA for encapsulation and a back panel, wherein an EVA material is used for encapsulation between the ultra clear glass and the cell string and between the cell string and the back panel; and making sure that the first film containing metal oxides and/or silicon oxides is opposite to the cell string.

In this step, when the back panel is also glass, the back panel can use the glass including a second film containing metal oxides and/or silicon oxides, and the second film containing metal oxides and/or silicon oxides is opposite to the cell string.

D4: Laminating: the laminating temperature of the laminating machine is 150 degrees, and the laminating period is 10 minutes.

D5: Deburring and cleaning the photovoltaic module obtained in D4.

D6: Installing the frame: applying the glue, installing corner keys, punching holes, installing the frame and cleaning the residual glue.

D7: Welding a junction box.

D8: Testing and inspecting.

The photovoltaic module shown in FIG. 14 can be obtained through the above Embodiment 4.

### Example 5:

E1: Selecting cells including a first film containing metal oxides and/or silicon oxides, wherein the first film (for example, a 15-nanometer aluminum oxide film) is deposited on the surface of an anti-reflection layer (for example, a silicon nitride film layer) of a cell.

E2: Welding the crystalline silicon cells to form a cell string.

In this step, welding can be performed manually or by a welding machine.

E3: Preparing the materials required for the production of the module, including materials such as ultra clear glass, EVA for encapsulation, a cell string, a back panel, silica gel, and a frame.

E4: Arranging in a sequence of the ultra clear glass, an EVA material for encapsulation, a cell string including a barrier layer, EVA for encapsulation, and a back panel, and making sure that the first film is opposite to the ultra clear glass.

E5: Laminating: the laminating temperature of the laminating machine is 150 degrees, and the laminating period is 10 minutes.

E6: Deburring and cleaning the photovoltaic module obtained in E5.

E7: Installing the frame: applying the glue, installing corner keys, punching holes, installing the frame and cleaning the residual glue.

E8: Welding a junction box.

E9: Testing and inspecting.

It should be noted that: the production method for a photovoltaic module provided in each of the above embodiments may further comprise a step of assembling a bus bar, an inverter and a connector into the photovoltaic module. The step is consistent with that in the prior art (details are omitted).

## Claims

1. A photovoltaic module (100) comprising:
a glass panel (101), a back panel (102), and a cell string (103) including a plurality of cells (1031) encapsulated between the glass panel (101) and the back panel (102);
wherein the photovoltaic module (100) further comprises a first film (104) containing metal oxides and/or silicon oxides disposed between the glass panel (101) and the cell string (103), wherein each of the cells (1031) has a part of the first film (104) deposited thereon,
**characterized in that** the glass panel (101) also has a part of the first film (104) deposited thereon.

2. The photovoltaic module (100) according to claim 1, **characterized in that** each of the cells (1031) includes a first anti-reflection layer (10311) on which the first film (104) is deposited.

3. The photovoltaic module (100) according to any of the preceding claims, **characterized in that** a material of the back panel (102) is glass.

4. The photovoltaic module (100) according to claim 3, **characterized in that** the photovoltaic module (100) further comprises a second film (105) containing metal oxides and/or silicon oxides disposed between the back panel (102) and the cell string (103).

5. The photovoltaic module (100) according to claim 4, **characterized in that** at least one of the cells (1031) has a part of the second film (105) deposited thereon.

6. The photovoltaic module (100) according to claim 5, **characterized in that** each of the plurality of cells (1031) includes a second anti-reflection layer (10312) on which the second film (105) is deposited.

7. The photovoltaic module (100) according to any of claims 4 to 6, **characterized in that** the back panel (102) has a part of the second film (105) deposited thereon.

8. The photovoltaic module (100) according to claim 1, **characterized in that** the first film (104) is a single-layer or a laminated structure (109).

9. The photovoltaic module (100) according to claim 4, **characterized in that** the second film (105) is a single-layer or a laminated structure (109).

10. The photovoltaic module (100) according to claim 1, **characterized in that** the first film (104) has a thickness of 2 to 5000nm.

11. The photovoltaic module (100) according to claim 4, **characterized in that** the second film (105) has a thickness of 2 to 5000nm.

12. The photovoltaic module (100) according to one of claims 1 and 4, **characterized in that** the metal oxides include any one or more of aluminum oxide, zinc oxide, zirconium oxide, titanium oxide, and tin oxide.

## Patentansprüche

1. Fotovoltaikmodul (100), Folgendes umfassend:
eine Glasplatte (101), eine Rückseitenplatte (102) und einen Zellenstring (103), der mehrere Zellen (1031) umfasst und zwischen der Glasplatte (101) und der Rückseitenplatte (102) eingekapselt ist;
wobei das Fotovoltaikmodul (100) ferner einen ersten Film (104) umfasst, der Metalloxide und/oder Siliciumoxide enthält und zwischen der Glasplatte (101) und dem Zellenstring (103) angeordnet ist, wobei auf jeder der Zellen (1031) ein Teil des ersten Films (104) angeordnet ist,
**dadurch gekennzeichnet, dass** auf der Glasplatte (101) ebenfalls ein Teil des ersten Films (104) angeordnet ist.

2. Fotovoltaikmodul (100) nach Anspruch 1, **dadurch gekennzeichnet, dass** jede der Zellen (1031) eine erste Antireflexschicht (10311) umfasst, auf welcher der erste Film (104) angeordnet ist.

3. Fotovoltaikmodul (100) nach einem der vorhergehenden Ansprüche, **dadurch gekennzeichnet, dass** ein Material der Rückseitenplatte (102) Glas ist.

4. Fotovoltaikmodul (100) nach Anspruch 3, **dadurch gekennzeichnet, dass** das Fotovoltaikmodul (100) ferner einen zweiten Film (105) umfasst, der Metalloxide und/oder Siliciumoxide enthält und zwischen der Rückseitenplatte (102) und dem Zellenstring (103) angeordnet ist.

5. Fotovoltaikmodul (100) nach Anspruch 4, **dadurch gekennzeichnet, dass** auf wenigstens einer der Zellen (1031) ein Teil des zweiten Films (105) angeordnet ist.

6. Fotovoltaikmodul (100) nach Anspruch 5, **dadurch gekennzeichnet, dass** jede der mehreren Zellen (1031) eine zweite Antireflexschicht (10312) umfasst, auf welcher der zweite Film (105) angeordnet ist.

7. Fotovoltaikmodul (100) nach einem der Ansprüche 4 bis 6, **dadurch gekennzeichnet, dass** auf der Rückseitenplatte (102) ein Teil des zweiten Films (105) angeordnet ist.

8. Fotovoltaikmodul (100) nach Anspruch 1, **dadurch gekennzeichnet, dass** der erste Film (104) eine einschichtige oder eine laminierte Struktur (109) ist.

9. Fotovoltaikmodul (100) nach Anspruch 4, **dadurch gekennzeichnet, dass** der zweite Film (105) eine einschichtige oder eine laminierte Struktur (109) ist.

10. Fotovoltaikmodul (100) nach Anspruch 1, **dadurch gekennzeichnet, dass** der erste Film (104) eine Dicke von 2 bis 5000 nm aufweist.

11. Fotovoltaikmodul (100) nach Anspruch 4, **dadurch gekennzeichnet, dass** der zweite Film (105) eine Dicke von 2 bis 5000 nm aufweist.

12. Fotovoltaikmodul (100) nach einem der Ansprüche 1 und 4, **dadurch gekennzeichnet, dass** die Metalloxide eines oder mehrere aus Aluminiumoxid, Zinkoxid, Zirconiumoxid, Titanoxid und Zinnoxid umfassen.

## Revendications

1. Module photovoltaïque (100) comprenant :
un panneau de verre (101), un panneau arrière (102) et une chaîne de cellules (103) comprenant une pluralité de cellules (1031) encapsulées entre le panneau de verre (101) et le panneau arrière (102) ;
dans lequel le module photovoltaïque (100) comprend en outre un premier film (104) contenant des oxydes métalliques et/ou des oxydes de silicium disposé entre le panneau de verre (101) et la chaîne de cellules (103), chacune des cellules (1031) ayant un une partie du premier film (104) déposée dessus,
**caractérisé en ce que** le panneau de verre (101) comporte également une partie du premier film (104) déposée dessus.

2. Module photovoltaïque (100) selon la revendication 1, **caractérisé en ce que** chacune des cellules (1031) comprend une première couche antireflet (10311) sur laquelle est déposé le premier film (104).

3. Module photovoltaïque (100) selon l'une quelconque des revendications précédentes, **caractérisé en ce qu'**un matériau du panneau arrière (102) est du verre.

4. Module photovoltaïque (100) selon la revendication 3, **caractérisé en ce que** le module photovoltaïque (100) comprend en outre un deuxième film (105) contenant des oxydes métalliques et/ou des oxydes de silicium disposé entre le panneau arrière (102) et le train de cellules (103).

5. Module photovoltaïque (100) selon la revendication 4, **caractérisé en ce qu'**au moins une des cellules (1031) est recouverte d'une partie du deuxième film (105).

6. Module photovoltaïque (100) selon la revendication 5, **caractérisé en ce que** chacune de la pluralité de cellules (1031) comprend une deuxième couche antireflet (10312) sur laquelle un deuxième film (105) est déposé.

7. Module photovoltaïque (100) selon l'une quelconque des revendications 4 à 6, **caractérisé en ce que** le panneau arrière (102) est recouvert d'une partie du deuxième film (105).

8. Module photovoltaïque (100) selon la revendication 1, **caractérisé en ce que** le premier film (104) est une structure monocouche ou feuilletée (109).

9. Module photovoltaïque (100) selon la revendication 4, **caractérisé en ce que** le deuxième film (105) est une structure monocouche ou feuilletée (109).

10. Module photovoltaïque (100) selon la revendication 1, **caractérisé en ce que** le premier film (104) a une épaisseur de 2 à 5000 nm.

11. Module photovoltaïque (100) selon la revendication 4, **caractérisé en ce que** le deuxième film (105) a une épaisseur de 2 à 5 000 nm.

12. Module photovoltaïque (100) selon l'une des revendications 1 et 4, **caractérisé en ce que** les oxydes métalliques comprennent l'un ou plusieurs parmi l'oxyde d'aluminium, l'oxyde de zinc, l'oxyde de zirconium, l'oxyde de titane et l'oxyde d'étain.
